(19) Europäisches Patentamt
European Patent Office
Office européen des brevets

(11) **EP 2 475 062 A2**

(12) **EUROPEAN PATENT APPLICATION**

(43) Date of publication:
**11.07.2012 Bulletin 2012/28**

(51) Int Cl.:
***H02J 5/00*** (2006.01)

(21) Application number: **11182363.9**

(22) Date of filing: **22.09.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **05.01.2011 JP 2011000719**

(71) Applicant: **Showa Aircraft Industry Co., Ltd.**
**Tokyo**
**196-0014 (JP)**

(72) Inventors:
• **Yamamoto, Kitao**
**Akishima-shi, Tokyo 196-0014 (JP)**

• **Sato, Takeshi**
**Akishima-shi, Tokyo 196-0014 (JP)**
• **Abe, Keisuke**
**Akishima-shi, Tokyo 196-0014 (JP)**
• **Mochizuki, Masashi**
**Akishima-shi, Tokyo 196-0014 (JP)**
• **Okiyoneda, Yasuyuki**
**Akishima-shi, Tokyo 196-0014 (JP)**

(74) Representative: **Piésold, Alexander James**
**Dehns**
**St Bride's House**
**10 Salisbury Square**
**London**
**EC4Y 8JD (GB)**

(54) **Non-contact power feeding apparatus for implementing magnetic resonance method**

(57)    In this non-contact power feeding apparatus 15, a power feeding side circuit 6 is provided with a power transmission coil 3 and a parallel capacitor 11 to provide a parallel resonance circuit, while a power receiving side circuit 7 is provided with a power receiving coil 4 and a parallel capacitor 12 to provide a parallel resonance circuit. Both parallel resonant circuits are set to have the same resonance frequency and a power frequency of a high-frequency power source 9 in the power feeding side circuit 6 is set to be the same as this resonance frequency. The power feeding side circuit 6 is provided in such a manner that a circuit section on the side of the high-frequency power source 9 and a circuit section on the side of the parallel capacitor 11 and the power transmission coil 3 are connected by the electric field coupling of the electric field coupling capacitors 21 and 21.

FIG. 1

**Description**

**BACKGROUND OF THE INVENTION**

**1. Field of the Invention**

The present invention relates to a non-contact power feeding apparatus, and more particularly to a non-contact power feeding apparatus for implementing a magnetic resonance method in which power is fed with no contact from, for example, a power feeding side on the side of a ground surface to a power receiving side on the side of a vehicle.

**2. Technological background**

A non-contact power feeding apparatus adapted to feed power from outside to, for example, a vehicle such as an electric vehicle without any mechanical contact such as a cable has been developed based on the demand and this apparatus is in practical use.

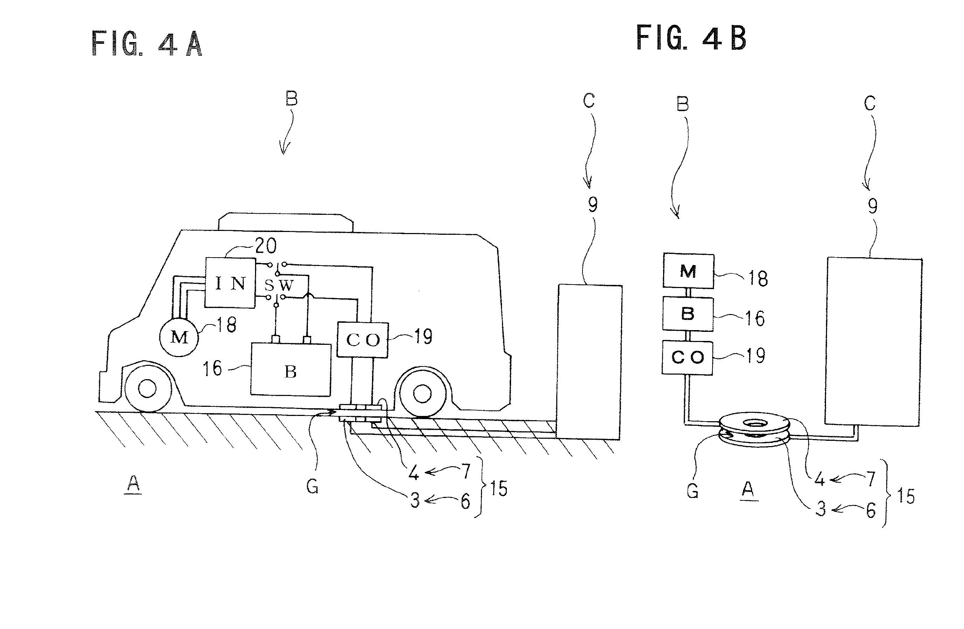

In such a non-contact power feeding apparatus, power is fed from a power transmission coil of a power feeding side circuit fixedly disposed on the ground side to a power receiving coil of a power receiving side circuit mounted on the side of a movable body such as a vehicle, which are closely disposed to face each other, through an air gap of, for example, tens of millimeters to hundreds of millimeters, based on a mutual induction effect of electromagnetic induction (refer to Fig. 4 described below).

**3. Description of the Prior Art**

In the non-contact power feeding apparatus of this type, there is a strong need for expansion of an air gap, that is, realization of a large air gap, in view of the needs for supply of a large amount of power and the convenience in the case of power feeding. Research and development of a magnetic resonance method are making progress in an effort to meet these needs.

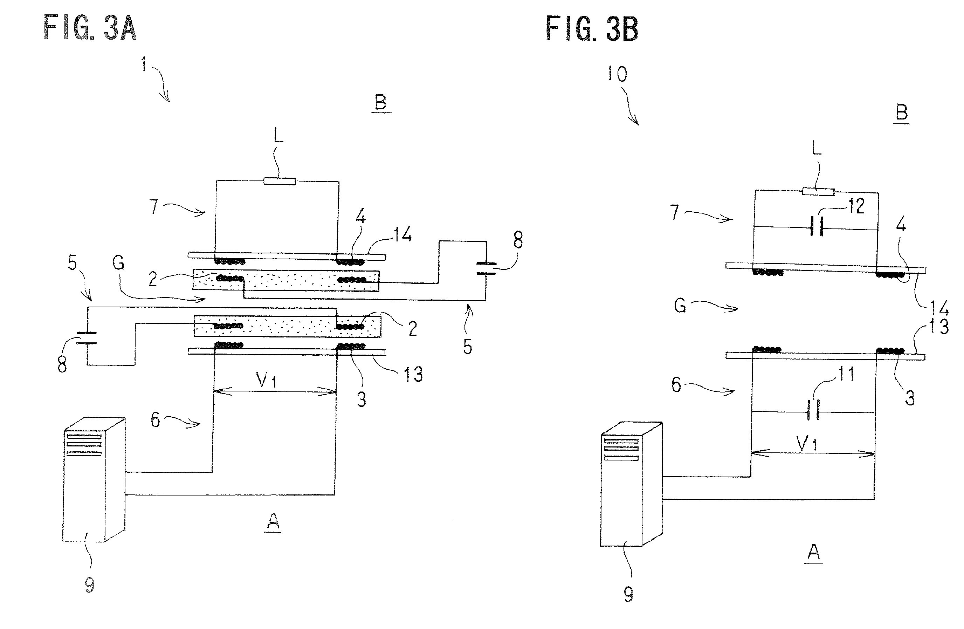

As typically shown in Fig. 3A as an example of a conventional technology, the magnetic resonance method is applied to and in practical use in a non-contact power feeding apparatus 1 in which a single or a number of repeating coils 2 are used.

Referring to the non-contact power feeding apparatus 1 as shown in Fig. 3A, as a premise, a repeating coil 2 constituting a resonance circuit 5 is disposed on each side of the power transmission coil 3 and the power receiving coil 4 in a magnetic path of an air gap G between the power transmission coil 3 and the power receiving coil 4. Both resonance circuits 5 are electrically insulated from a power feeding side circuit 6 such as the power transmission coil 3 and a power receiving side circuit 7 such as the power receiving coil 4 to provide an independent circuit. Both resonance circuits 5 are adapted to feed exciting reactive power to the magnetic path of the air gap G. Reference numeral 8 of the figure is a capacitor for resonance in the resonance circuit 5.

As the magnetic resonance method, both resonance circuits 5 are set to have the same resonance frequency, wherein electromagnetic coupling is made between the repeating coils 2 to serve as the magnetic resonance coils and a power frequency of a high-frequency power source 9 in the power feeding side circuit 6 is set to be the same as the resonance frequency.

For example, as shown in the conventional technology of Fig. 3A, the magnetic resonance method is typically applied to and used in the non-contact power feeding apparatus 1 in which the repeating coil 2 is used.

On the contrary, for example, as shown in the conventional technology of Fig. 3B, the magnetic resonance method can also be applied to and used in a non-contact power feeding apparatus 10 in which the repeating coil 2 is not used.

Referring to this non-contact power feeding apparatus 10, a power feeding side circuit 6 is provided with a power transmission coil 3 and a parallel capacitor 11 to provide a parallel resonance circuit, while a power receiving side circuit 7 is provided with a power receiving coil 4 and a parallel capacitor 12 to provide a parallel resonance circuit.

In the magnetic resonance method of this type, the power transmission coil 3 and the power receiving coil 4 are used as a magnetic resonance coil, wherein both parallel resonant circuits are set to have the same resonance frequency and a power frequency of a high-frequency power source 9 in the power feeding side circuit 6 is set to be the same as this resonance frequency. Reference numerals 13 and 14 are magnetic cores such as a ferrite core and reference symbol L is a load.

A type where the magnetic resonance method is applied to and implemented in the non-contact power feeding apparatus 10 as shown in Fig. 3B has the advantage in that more power can be fed due to decrease in a resistance value and the like than in a type where the magnetic resonance method is applied to and implemented in the non-contact power feeding apparatus 1 as shown in Fig. 3A. In this case, reduction of coupling coefficient K in the electromagnetic coupling associated with a large air gap G can be covered by Q-value of a coil. In other words, it is possible to maintain the efficiency between the coils by adopting the power transmission coil 3 and the power receiving coil 4 which have much less resistance component than the mutual inductance between the power transmission coil 3 and the power receiving coil 4.

**4. Prior art documents**

**(Patent Documents)**

For example, the following patent document 1 is cited as the type where the magnetic resonance method is applied to and implemented in the non-contact power feeding apparatus 1 as shown in Fig. 3A.
Refer to, for example, Figs. 3A and 3B of the patent document 1 for the type where the magnetic resonance method is applied to and implemented in the non-contact power feeding apparatus 10 as shown in Fig. 3B.
[Patent Document 1] Japanese Unexamined Patent Publication No. 2010-173503

**5. Problems to be solved by the Invention**

**(Problems)**

It has been pointed out that such a conventional non-contact power feeding apparatus 10 for implementing a magnetic resonance method has the following problems.
The magnetic resonance method has the advantage of being able to expand an air gap G. In such a magnetic resonance method, a large amount of power can be fed, with no contact, under such a large air gap G of which the coupling coefficient K of electromagnetic coupling between the power transmission coil 3 and the power receiving coil 4 is 0.1 or less. However, in the conventional non-contact power feeding apparatus 10 for implementing a magnetic resonance method, it has been pointed out that the exciting apparent power for exciting the power transmission coil 3 becomes extremely large, a high-frequency power source 9 of high capacity is required and it costs too much.
For example, when running a simulation for the non-contact power feeding apparatus 10 of Fig. 3, in the case where K-value is 0.05, when power of about 2 kW (output voltage: $V_2$ 420V x 5A) is fed to the power receiving side circuit 7, the exciting apparent power of the power feeding side circuit 6 becomes larger than 130 kVA (1.4 kV x 96A).
In other words, the input voltage V1 into the power transmission coil 3 requires a high voltage exceeding 1.4 kV, wherein it is necessary to produce such a high voltage in the resonance circuit of the power feeding side circuit 6. After all, it is necessary to feed the high voltage by the high-frequency power source 9 and/or a transformer. In this manner, in the magnetic resonance method of the type where the power transmission coil 3 and the power receiving coil 4 are used as a magnetic resonance coil, it has been pointed out that a high-voltage, high-capacity inverter power and/or a step-up transformer are necessary and a power-supply unit costs much.

**SUMMARY OF THE INVENTION**

**1. Present Invention**

A non-contact power feeding apparatus for implementing a magnetic resonance method according to the present invention was developed to solve the problems of the conventional technology described above, that is, the non-contact power feeding apparatus 10 for implementing a magnetic resonance method.
It is therefore an object of at least the preferred embodiments of the present invention to provide an improved non-contact power feeding apparatus for implementing a magnetic resonance method in which, first, it is not necessary to use a high-pressure and high-capacity power-supply unit, second, expansion of an air gap and supply of a large amount of power can be realized, and, third, the electromagnetic disturbance can also be prevented.

**2. Means for solving the problems**

A technical means of the present invention is as follows as per claims 1~7.

(Aspect 1)

A non-contact power feeding apparatus for implementing a magnetic resonance method is provided, in which power is fed through an air gap, with no contact, from a power transmission coil of a power feeding side circuit to a power receiving coil of a power receiving side circuit, which are closely disposed to face each other, based on a mutual induction effect of electromagnetic induction.

The power feeding side circuit is provided with the power transmission coil and a parallel capacitor connected in parallel to the power transmission coil to provide a parallel resonance circuit. The power receiving side circuit is also provided with the power receiving coil and a parallel capacitor connected in parallel to the power receiving coil to provide a parallel resonance circuit.

Both parallel resonance circuits are set to have the same resonance frequency and a power frequency of a high-frequency power source in the power feeding side circuit is set to be the same as the resonance frequency. The power feeding side circuit is provided in such a manner that a circuit section on the side of the high-frequency power source and a circuit section on the side of the parallel capacitor and the power transmission coil are connected by electric field coupling of electric field coupling capacitors.

Further, as described in the following aspects 2 through 7, the non-contact power feeding apparatus for implementing a magnetic resonance method according to the present invention can be modified by adding technically limited elements.

(Aspect 2)

In a preferred non-contact power feeding apparatus for implementing a magnetic resonance method, the electric field coupling capacitors fulfill a pressure rising function to keep the pressure of the circuit section on the side of the high-frequency power source low and keep the pressure of the circuit section on the side of the power transmission coil and the like high.

(Aspect 3)

In a preferred non-contact power feeding apparatus for implementing a magnetic resonance method, the power feeding side circuit is provided in such a manner that the circuit section on the side of a high-frequency power source and the circuit section on the side of the electric field coupling capacitors, the parallel capacitor and the power transmission coil are connected through an insulating transformer.

(Aspect 4)

In a preferred non-contact power feeding apparatus for implementing a magnetic resonance method, the power feeding side circuit such as the power transmission coil is fixedly disposed on the side of a ground surface, a road surface, a floor surface or other ground, while the power receiving side circuit such as the power receiving coil is mounted on the side of a vehicle or other movable body.

(Aspect 5)

In a preferred non-contact power feeding apparatus for implementing a magnetic resonance method, power is fed by a stopped-type power feeding method whereby, in the case of power feeding, the power receiving coil is stopped to closely face the stationary power transmission coil through an air gap. The power transmission coil and the power receiving coil are formed in a paired symmetric structure.

(Aspect 6)

In a preferred non-contact power feeding apparatus for implementing a magnetic resonance method, the power transmission coil and the power receiving coil are respectively provided in such a manner that each insulated coil conducting wire is spirally wound more than once on the same plane to provide a totally flat and thin structure.

**(Aspect 7)**

In a preferred non-contact power feeding apparatus for implementing a magnetic resonance method, the resonance frequency is set based on the frequency response of an output voltage of the power receiving coil to an input voltage into the power transmission coil and the resonance frequency is set to the intermediate frequency of both peaks of bimodal characteristics relating to a specified coupling coefficient in view of the fact that the frequency response shows the bimodal characteristics while responding to the coupling coefficient of the electromagnetic coupling.

**3. Operation etc.**

Operation and the like of the present invention will now be described in the following items (1) through (11).

(1) In the non-contact power feeding apparatus, power is fed through an air gap by causing the power receiving coil to be closely located to face the power transmission coil.
(2) In the case of power feeding, the power transmission coil is energized to provide a magnetic flux, wherein a magnetic path of the magnetic flux is formed in the air gap between the power transmission coil and the power receiving coil.
(3) By utilizing the magnetic field induced in the item (2), power is fed from the side of the power transmission coil to the side of the power receiving coil based on the mutual induction effect of the electromagnetic induction.
(4) The power feeding side circuit is provided with the power transmission coil and a parallel capacitor to provide a parallel resonance circuit. The power receiving side circuit is provided with the power receiving coil and a parallel capacitor to provide a parallel resonance circuit. In this manner, a magnetic resonance method is provided in which the resonance frequency of both parallel resonance circuits is set to be the same as the power frequency of a high-frequency power source.
(5) The power transmission coil and the power receiving coil are used as a magnetic resonance coil by the item (4). In view of expansion of the air gap, the exciting apparent power to the power transmission coil becomes large, wherein large input voltage and current are needed.
(6) Since a large current is obtained in the parallel resonance circuit, a large amount of power can be realized on the side of the power transmission coil with the side of the power-supply unit remaining in small current and capacity.
(7) With this, the high-frequency power source side of the power feeding side circuit is connected to the side of the power transmission coil and the like by electric field coupling capacitors. The pressure rising function of the electric field coupling capacitors keeps the pressure of the high-frequency power source low and keeps the pressure of the power transmission coil and the like high. Thus, a large amount of power and high pressure on the side of the power transmission coil can be realized with the side of the power-supply unit remaining in low pressure and small capacity.
(8) Of course, since the non-contact power feeding apparatus employs the magnetic resonance method, a large amount of power can be realized by expansion of the air gap. Since the air gap is not provided with an independent resonance circuit, a large amount of power can be fed accordingly.
(9) When the high-frequency power source of the power feeding side circuit is connected through an insulating transformer, a common-mode current is reduced to lower unnecessary electromagnetic waves radiated outside.
(10) The non-contact power feeding apparatus of a magnetic resonance method according to the present invention has the following effects.

**4. Effects of the Invention**

**(First effect)**

First, the voltage of the power transmission coil can be increased without using a high-voltage, high-capacity power-supply unit.
The non-contact power feeding apparatus for implementing a magnetic resonance method is composed of a type where the power transmission coil and the power receiving coil are used as a magnetic resonance coil and a large exciting apparent power is required in the power transmission coil for expansion of the air gap. In the case of the present invention, the side of the power transmission coil and the like is connected to the side of the high-frequency power source of the power feeding side circuit by electric field coupling by electric field coupling capacitors to keep the pressure and capacity of the high-frequency power source low and to keep the pressure of the side of the power transmission coil and the like high. With this, since a resonance capacitor is connected in parallel to the power transmission coil, it is possible to keep the current and capacity of the side of the high-frequency power source low and to make the power of the side of the power transmission coil and the like large.
Accordingly, the problems of the conventional technology of this kind that high-voltage and high-capacity inverter power and transformer are required and the power-supply unit increases in cost can be resolved. In the present invention, it is possible to make the pressure of the power transmission coil high without the need for high pressure and high capacity of the high-frequency power source and without the need for pressure-rising and high pressure by the transformer. Since power can be fed in low pressure and capacity on the side of the power-supply unit, a significant cost reduction can be realized.

**(Second effect)**

Second, expansion of the air gap and supply of a large amount of power can be realized. The non-contact power feeding apparatus of a magnetic resonance method according to the present invention is composed of a type where the power transmission coil and the power receiving coil are used as a magnetic resonance coil.

In this manner, by utilizing the characteristics of the magnetic resonance method, supply of a large amount of power can be realized under expansion of an air gap, that is, a large air gap to improve the convenience in the case of power feeding. With this, it is possible to feed a larger amount of power than in the non-contact power feeding apparatus of a magnetic resonance method of a type where the repeating coil of the conventional technology has been used.

**(Third effect)**

Third, an electromagnetic disturbance can also be prevented. A high-frequency alternating current of about tens of kHz to hundreds of kHz is often used in this non-contact power feeding apparatus. Accordingly, an electric current containing high-order harmonic flows into a coil and as a result, a common-mode current also contains the high-order harmonic. There is a possibility that the electromagnetic waves radiated outside based on a magnetic field formed by the common-mode current may produce an electronic jamming to neighboring areas or a functional disorder to human bodies.

By providing an insulating transformer in the power feeding side circuit to prevent the flow of the common-mode current, unnecessary electromagnetic radiation is reduced and as a result, the risk of generating such an electromagnetic disturbance can be reduced.

The present invention has prominent effects in that all the problems of the conventional examples of this kind can be solved by the first, second and third effects.

**BRIEF DESCRIPTION OF THE DRAWINGS**

The above and other objects, features and advantages of the present invention will become more apparent from the following description when taken in conjunction with the accompanying drawings.

Fig. 1 is a circuit diagram for explaining an embodiment of a non-contact power feeding apparatus of a magnetic resonance method according to the present invention;

Fig. 2 is provided to explain an embodiment of the non-contact power feeding apparatus of a magnetic resonance method, wherein Fig. 2A is an explanatory circuit diagram for explaining the principle and Fig. 2B is a frequency response graph of the output voltage;

Fig. 3 is provided to explain a conventional non-contact power feeding apparatus of a magnetic resonance method, wherein Fig. 3A is an explanatory circuit diagram of one example and Fig. 3B is an explanatory circuit diagram of another example; and

Fig. 4 is provided to generally explain a non-contact power feeding apparatus, wherein Fig. 4A is an overall side view and Fig. 4B is a configuration block diagram.

**DETAILED DESCRIPTION OF THE PREFERRED EMBODIMENTS**

A preferred embodiment of the present invention will now be fully described hereunder, by way of example only.

**(Non-contact power feeding apparatus 15)**

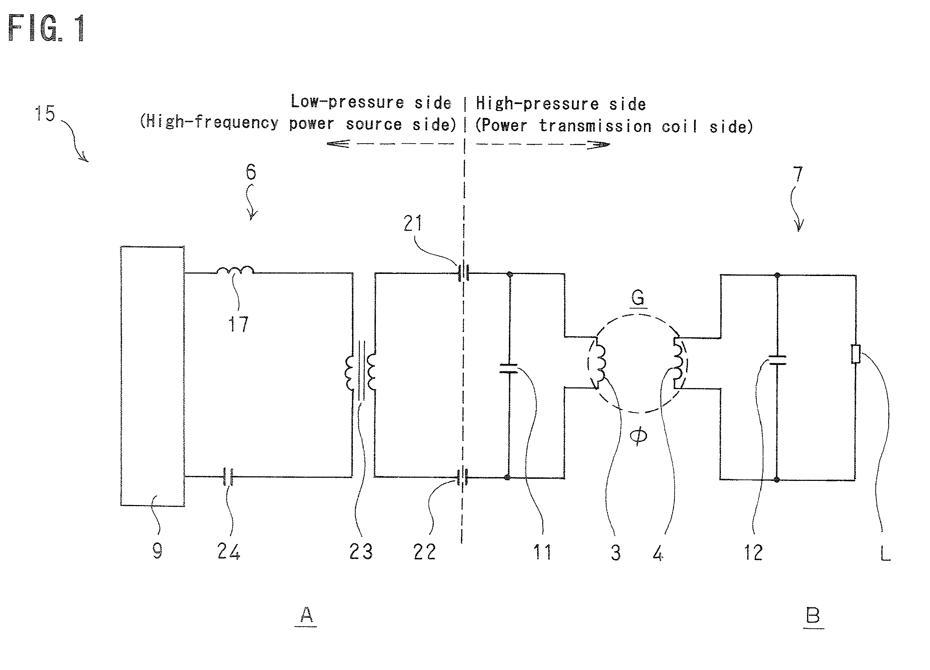

First, a non-contact power feeding apparatus 15 which becomes the premise of the present invention will be generally described with reference to Figs. 1, 2A and 4.

The non-contact power feeding apparatus 15 is provided in such a manner that power can be fed through an air gap G, with no contact, from a power transmission coil 3 of a power feeding side circuit 6 to a power receiving coil 4 of a power receiving side circuit 7, which are closely located to face each other, based on a mutual induction effect of the electromagnetic induction.

The power feeding side circuit 6 is fixedly disposed on the side of the ground A, while the power receiving side circuit 7 is mounted on the side of a movable body such as a vehicle B.

**(Details of the non-contact power feeding apparatus 15)**

Such a non-contact power feeding apparatus 15 will be further described. First, a circuit will be described. A power feeding side circuit 6 referred to as a power feeding side, a track side or a primary side is fixedly disposed on the side of a ground surface, a road surface, a floor surface or other ground A in a power feeding area such as a power feeding stand C.

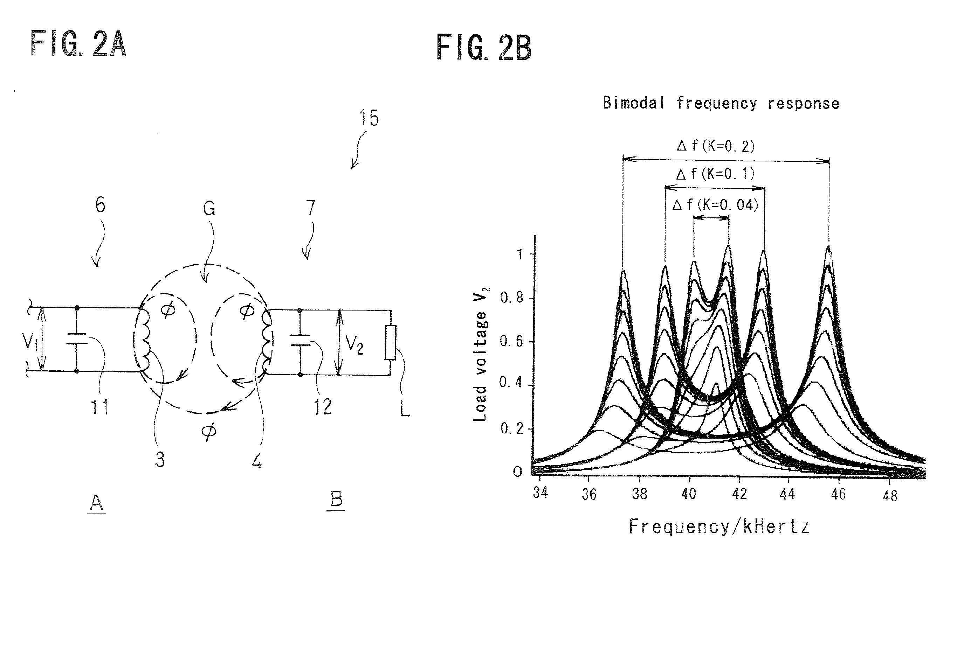

As opposed to this, a power receiving side circuit 7 referred to as a power receiving side, a pickup side or a secondary side is mounted on the side of a vehicle B such as an electric vehicle or an electric train, or other movable bodies. The power receiving side circuit 7 is available not only for driving, but also for non-driving. As shown in Fig. 4, the power receiving side circuit 7 is usually connected to a car-mounted battery 16, but, as shown in Figs. 1 and 2A, it can also be connected direct to various types of loads L.

Next, a power feeding operation will be described. In the case of power feeding operation, the power transmission coil 3 of the power feeding side circuit 6 and the power receiving coil 4 of the power receiving side circuit 7 are closely located to face each other with no contact through an air gap G which is a small space of about tens of mm to hundred of mm, for example, 50 mm to 150 mm.

In the case of a power feeding operation, as shown in Figs. 1, 2A and 4, a stopped-type power feeding method is typical whereby the power receiving coil 4 is located to stop, for example, to park facing the stationary power transmission coil 3 from above, from the side or from other directions. In the case of the stopped-type power feeding method, the power transmission coil 3 and the power receiving coil 4 are formed in a paired symmetric structure in the vertical, lateral or other direction. However, a mobile-type power feeding method is also available whereby power feeding is conducted while the power receiving coil 4 runs at a low speed over the power transmission coil 3. To give an example of the mobile-type power feeding method, there is a case where power is fed to the electric vehicle running on an expressway.

Next, the coils etc. will be described. The power transmission coil 3 of the power feeding side circuit 6 is connected to a high-frequency power source 9. The high-frequency power source 9 is composed of an inverter power for converting a frequency and the like which applies a high frequency alternating current of about, for example, several kHz to tens of kHz, moreover, tens of kHz to hundreds of kHz, to the power transmission coil 3 as a power feeding alternating current, that is, an exciting current. In the power feeding side circuit 6 of Fig. 1, reference numeral 17 is a choke coil, 11 is a parallel capacitor for parallel resonance with the power transmission coil 3.

The power receiving coil 4 of the power receiving side circuit 7 can be connected to a battery 16 in an example as shown in Fig. 4, wherein a running motor 18 is driven by the battery 16 charged by the power feeding operation. On the contrary, in the examples of Figs. 1 and 2A, power is fed to another load L. Reference numeral 19 in Fig. 4 is a converter (a rectifying section and a smooth section) for converting an alternating current to a direct current and reference numeral 20 is an inverter for converting the direct current to the alternating current. Reference numeral 12 in the power receiving side circuit 7 of Fig. 1 is a parallel capacitor for parallel resonance with the power receiving coil 4.

The power transmission coil 3 and the power receiving coil 4 are respectively formed in a spirally wound flat structure. In other words, the power transmission coil 3 and the power receiving coil 4 are provided in such a manner that each insulated coil conducting wire is spirally wound more than once in a circular or rectangular shape to provide a totally thin and flat structure in a circular or substantially flange shape while maintaining the parallel positional relationship juxtaposed on the same plane.

The power transmission coil 3 is provided with a magnetic core 13 such as a ferrite core on the opposite side, that is, the outer side, of an air gap G, while the power receiving coil 4 is also provided with a magnetic core 14 such as a ferrite core on the outer side of the air gap G (refer to Fig. 3). The magnetic cores 13 and 14 are made of a ferromagnetic body of a flat, circular or substantially flange shape and have a slightly larger surface area than the power transmission coil 3 and the power receiving coil 4. The magnetic cores 13 and 14 are concentrically disposed with the power transmission coil 3 and the power receiving coil 4. The magnetic cores 13 and 14 increases the inductance between coils to strengthen the electromagnetic coupling and induces, collects and directs the formed magnetic flux.

Next, a mutual induction effect of electromagnetic induction will be described. It is publicly known and used in practice that, in the case of power feeding operation, the power transmission coil 3 and the power receiving coil 4 are closely located to face each other through the air gap G and a magnetic flux is formed in the power transmission coil 3 to generate induced electromotive force in the power receiving coil 4, wherein electric power is fed from the power transmission coil 3 to the power receiving coil 4.

In other words, as shown in Figs. 1 and 2A, the self-induced electromotive force is caused to generate by applying a power feeding alternating current, that is, an exciting current to the power transmission coil 3 of the power feeding side circuit 6 from the high-frequency power source 9, wherein a magnetic field is generated around the power transmission coil 3 and a magnetic flux $\phi$ is formed in the direction perpendicular to the coil surface.

The magnetic flux $\phi$ formed in this way goes through and interlinks the power receiving coil 4 of the power receiving side circuit 7 and the induced electromotive force is generated in the power receiving coil 4 to form the magnetic field. In this manner, by utilizing the induced magnetic field, the electric power is sent and received and as a result, power of about several kW, moreover, tens of kW to hundreds of kW can be fed. A magnetic circuit of the magnetic flux $\phi$, that is, a magnetic path is formed and electromagnetically coupled between the magnetic circuit of the magnetic flux $\phi$ on the side of the power transmission coil 3 and the magnetic circuit of the magnetic flux $\phi$ on the side of the power receiving coil 4.

In the non-contact power feeding apparatus 15, the non-contact power feeding operation is conducted based on such a mutual induction effect of electromagnetic induction. The general description of the non-contact power feeding apparatus 15 is as above.

**(Outline of preferred embodiments of the present invention)**

A non-contact power feeding apparatus 15 of the embodiments of the present invention will now be described with reference to Figs. 1 and 2. First, an outline of the present invention is as follows.

In this non-contact power feeding apparatus 15, a power feeding side circuit 6 is provided with a power transmission coil 3 and a parallel capacitor 11 connected in parallel to the power transmission coil 3 to provide a parallel resonance circuit, while a power receiving side circuit 7 is also provided with a power receiving coil 4 and a parallel capacitor 12 connected in parallel to the power receiving coil 4 to provide a parallel resonance circuit.

This non-contact power feeding apparatus 15 is composed of a magnetic resonance method whereby both parallel resonance circuits are set to have the same resonant frequency and a power frequency of a high-frequency power source 9 in the power feeding side circuit 6 is set to be the same as the resonance frequency.

In the non-contact power feeding apparatus 15 of the present invention, the power feeding side circuit 6 is provided in such a manner that a circuit section on the side of the high-frequency power source 9 and a circuit section on the side of the parallel capacitor 11 and the power transmission coil 3 are connected by electric field coupling by electric field coupling capacitors 21 and 22. The electric field coupling capacitors 21 and 22 fulfill a pressure rising function to keep the pressure of the circuit section on the side of the high-frequency power source 9 low and keep the pressure of the circuit section on the side of the power transmission coil 3 and the like high.

In this manner, the exciting apparent power of the power transmission coil 3 become large by a high current of the power transmission coil 3 due to resonance and a high pressure by the electric field coupling capacitors 21 and 22.

The outline of the preferred embodiments of the present invention is as described above. The preferred embodiments of the present invention will now be further described hereunder.

**(Magnetic resonance method)**

First, a magnetic resonance method will be described with reference to Fig. 2 and the like. As described above, it is known that a mutual induction effect of electromagnetic induction is used in the non-contact power feeding operation. However, in addition to the mutual induction effect, a technology using a magnetic resonance method is also attracting attention in recent years. In other words, when the magnetic resonance method is concurrently used in the non-contact power feeding operation, a large amount of power can be fed even under a large air gap G.

In the present invention premised on the magnetic resonance method, the side of the power transmission coil 3 and the side of the power receiving coil 4, which are electromagnetically coupled by a mutual magnetic flux $\phi$ and have the same resonance frequency, are closely located to face each other through the air gap G in the case of power feeding operation, and the exciting current of the same frequency as the resonance frequency is applied between them from the high-frequency power source 9. With this, a magnetic resonance phenomenon is produced between the power transmission coil 3 and the power receiving coil 4, wherein further expansion of the air gap G can be realized to feed a large amount of power.

In the non-contact power feeding apparatus 15 of the present invention, as a premise, the power feeding side circuit 6 is provided with the power transmission coil 3 and the parallel capacitor 11 to provide the parallel resonance circuit, while the power receiving side circuit 7 is provided with the power receiving coil 4 and the parallel capacitor 12 to provide the parallel resonance circuit.

With this, in non-contact power feeding apparatus 15 of the present invention premised on the magnetic resonance method, the resonance frequency of the parallel resonance circuit of the power feeding side circuit 6 is set to be the same as that of the parallel resonance circuit of the power receiving side circuit 7 and the power frequency of the high-frequency power source in the power feeding side circuit 6 is also set to be the same as the resonant frequency.

The magnetic resonance method is as described above.

**(Frequency setting)**

Next, setting of the above frequency will be described with reference to Fig. 2 and the like. First, the resonance frequency $f_1$ (Hz) of the parallel resonance circuit in the power feeding side circuit 6 is determined by a self-inductance $L_1$ (H) of the power transmission coil 3 and a capacitance $C_1$ (F) of the parallel capacitor 11.

Further, the resonant frequency $f_2$ (Hz) of the parallel resonance circuit of the power receiving side circuit 7 is determined by a self-inductance $L_2$ (H) of the power receiving coil 4 and a capacitance $C_2$ (F) of the parallel capacitor 12.

Both resonance frequencies $f_1$ and $f_2$ are set to be the same. The resonance frequencies $f_1$ and $f_2$ are expressed in the following mathematical formulas 1 and 2.

$$(\text{Formula 1})$$

$$f_1 = \frac{1}{2\pi\sqrt{L_1 C_1}}$$

$$(\text{Formula 2})$$

$$f_2 = \frac{1}{2\pi\sqrt{L_2 C_2}}$$

Setting of a specific frequency is as follows. First, as a premise, a frequency response of an output voltage $V_2$ of the power receiving coil 4 in the power receiving side circuit 7 to an input voltage $V_1$ into the power transmission coil 3 in the power feeding side circuit 6 becomes the proportion shown in Fig. 2B and shows bimodal characteristics.

In the case where the air gap G distance between the power transmission coil 3 and the power receiving coil 4 is too large, a frequency response of the output voltage $V_2$ shows monomodal characteristics. On the contrary, in the case where the air gap G distance is too small to be capable of feeding power, the frequency response shows bimodal characteristics as shown in the figure while corresponding to a coupling coefficient K for electromagnetic coupling.

The coupling coefficient K shows the degree of electromagnetic coupling between the power transmission coil 3 and the power receiving coil 4 and is expressed in the following mathematical formula 3. M (H) is a mutual inductance and K-value takes the value between 0 and 1 in proportion to the length of the air gap G distance. When the distance is large, a leakage magnetic flux increases to let K-value come closer to 0, while when the distance is small, K-value comes closer to 1 and becomes 1 in a virtual state in which there is no leakage magnetic flux.

$$(\text{Formula 3})$$

$$K = \frac{M}{\sqrt{L_1 L_2}}$$

As shown in Fig. 2B, the frequency response of the output voltage $V_2$ of the power receiving coil 4 shows the bimodal characteristics, but the size of a frequency difference $\Delta f$ between the peaks is proportional to K-value. When the air gap G distance is small and K-value is large, the frequency difference $\Delta f$ widens. When the air gap G distance is large and K-value is small, the frequency difference $\Delta f$ narrows.

In the setting of the resonance frequency $f_2$, a specific coupling coefficient K is set to the intermediate frequency between the frequencies of both peaks showing such bimodal characteristics. In other words, the resonance frequency $f_2$ on the side of the power receiving coil 4 can be set to the intermediate frequency between the frequency of one peak and the frequency of another peak.

Likewise, the resonant frequency $f_1$ on the side of the power transmission coil 3 is also set to be the same as above and the power frequency of the high-frequency power source 9 is set to be the same as above. The self-inductances $L_1$ and $L_2$ of the power transmission coil 3 and the power receiving coil 4 are adjusted accordingly.

Frequency setting is as described above.

**(Electric field coupling capacitors 21 and 22)**

Next, electric field coupling capacitors 21 and 22 will be described with reference to Fig. 1. The power feeding side circuit 6 is provided in such a manner that a circuit section on the side of a high-frequency power source 9 and a circuit section of a power transmission coil 3 and a parallel capacitor 11 which constitute a parallel resonant circuit are connected by electric field coupling capacitors 21 and 22.

In other words, both ends of the power transmission coil 3 are respectively connected in series to the side of one electrode of both electric field coupling capacitors 21 and 22 through both connecting points of the parallel capacitor 11. On the contrary, the side of another electrode of both electric field coupling capacitors 21 and 22 are respectively connected in series to both ends of a secondary coil of an insulating transformer 23 in the example as shown in Fig. 1.

The electric field coupling capacitors 21 and 22 send and receive electric power by utilizing an electric line of force induced between each electrode and an electric field, but fulfill a pressure rising function by resonating with the power transmission coil 3.

In other words, both electric field coupling capacitors 21 and 22 resonate in parallel with the power transmission coil 3 while dividing voltage (the resonant frequency is set to be the same as the resonance frequency described above). In this manner, in the power feeding side circuit 6, the circuit section on the side of the high-frequency power source 9 and the insulating transformer 23 is kept at low pressure without bringing the circuit section into high pressure and pressure rising, while the circuit section on the side of the power transmission coil 3 and the parallel capacitor 11 are kept at high pressure together with the parallel capacitor 11.

The electric field coupling capacitors 21 and 22 are as described above.

**(Insulating transformer 23 etc.)**

Next, an insulating transformer 23 and the like will be described with reference to Fig. 1. The power feeding side circuit 6 is also provided with an insulating transformer 23 in the circuit section on the side of the high-frequency power source 9 which is kept at low pressure as described above. The circuit section on the side of the high-frequency power source 9 and the circuit section on the side of the electric field coupling capacitors 21 and 22, the parallel capacitor 11, the power transmission coil 3 and the like are connected through the insulating transformer 23.

In other words, one end of a secondary coil of the insulating transformer 23 is connected in series to one electric field coupling capacitor 21 and another end thereof is connected in series to another electric field coupling capacitor 22. On the contrary, one end of a primary coil of the insulating transformer 23 is connected in series to one end of the high-frequency power source 9 through a choke coil 17 and another end thereof is connected in series to another end of the high-frequency power source 9 through a capacitor 24.

The insulating transformer 23 functions to electrically insulate the side of the high-frequency power source 9 from the side of the power transmission coil 3 to reduce a common-mode current, thereby reducing the unnecessary radiation of electromagnetic waves based on the magnetic field formed by the power transmission coil 3.

It is, of course, possible to operate an inverter power of the high-frequency power source 9 at a proper operational point by transformation function of the insulating transformer 23, thereby helping improve the efficiency.

A choke coil 17 serves to attenuate a harmonic component other than a fundamental wave in the power feeding alternating current from the high-frequency power source 9. Namely, since a cost-efficient rectangular wave inverter is often used as the high-frequency power source 9 and the harmonic component is included in the power feeding alternating current, the choke coil 17 is provided to prevent the harmonic component from flowing into the parallel capacitor 11.

Further, a capacitor 24 is provided to block a direct-current component from flowing into the insulating transformer 23. In other words, the capacitor 24 prevents the direct-current component included in the power feeding alternating current from the high-frequency power source 9 from flowing into the insulating transformer 23, thereby preventing the performance deterioration of the insulating transformer 23.

The insulating transformer and the like are as described above.

**(Operation etc.)**

The non-contact power feeding apparatus 15 for implementing a magnetic resonance method according to the preferred embodiments of the present invention is constructed as described above. Operation and the like of the embodiments will be described in the following items 1 through 9.

1) In the non-contact power feeding apparatus 15, a power receiving coil 4 of a power receiving side circuit 7 mounted on the side of a movable body such as a vehicle B is closely located to face a power transmission coil 3 of a power feeding side circuit 6 fixedly disposed on the side of a ground A through an air gap G, with no contact, wherein power is fed from the power transmission coil 3 to the power receiving coil 4 (refer to Fig. 4).

2) In the case of power feeding, a high-frequency alternating current from a high-frequency power source 9 is applied to the power transmission coil 3 as an exciting current. In this manner, a magnetic flux $\phi$ is formed on the power transmission coil 3, wherein a magnetic path of the magnetic flux $\phi$ is formed in the air gap G between the power transmission coil 3 and the power receiving coil 4 (refer to Fig. 2A).

3) In this manner, the side of the power transmission coil 3 and the side of the power receiving coil 4 are electromagnetically coupled through the air gap G, wherein the magnetic flux $\phi$ goes through and interlinks the power receiving coil 4 to generate the induced electromotive force.

In the non-contact power feeding apparatus 15, by utilizing the induced magnetic field, power is fed from the power feeding side circuit 6 to the power receiving side circuit 7 based on the mutual induction effect of electromagnetic induction (refer to Figs. 1 and 2A).

4) Meanwhile, in this non-contact power feeding apparatus 15, the power feeding side circuit 6 is provided with the power transmission coil 3 and the parallel capacitor 11 to provide a parallel resonance circuit, while the power receiving side circuit 7 is provided with the power receiving coil 4 and the parallel capacitor 12 to provide a parallel resonance circuit.

With this, the non-contact power feeding apparatus 15 is composed of a magnetic resonance method whereby the resonance frequencies $f_1$ and $f_2$ of both parallel resonance circuits and a power frequency of the high-frequency power source 9 in the power feeding side circuit 6 is set to be the same (refer to Fig. 1).

5) This non-contact power feeding apparatus 15 of a magnetic resonance method is composed of a type where the power transmission coil 3 and the power receiving coil 4 are used as a magnetic resonance coil. Since the non-contact power feeding operation is conducted under a large air gap G of which K-value is 0.1 or less, the exciting apparent power to the power transmission coil 3 becomes large and thus, the input voltage $V_1$ into the power transmission coil 3a also requires a high voltage. Supply of high current to the power transmission coil 3 is realized by the parallel resonance circuit.

6) In the power feeding side circuit 6 of the present invention, the side of the high-frequency power source 9 and the side of the power transmission coil 3 and the like are connected by the electric field coupling capacitors 21 and 22 (refer to Fig. 1).

The electric field coupling capacitors 21 and 22 fulfill a pressure rising function to keep the pressure of the high-frequency power source 9 side of the power feeding side circuit 6 low and keep the pressure of the side of the power transmission coil 3 and the like high. In this manner, high pressure of the power transmission coil 3 can be realized with the power supply unit side kept in low-voltage and low-capacity without requiring high pressure and high capacity of the high-frequency power source 9 and pressure rising and high pressure by the transformer. Thus, supply of the large exciting apparent power to the power transmission coil 3 can be realized.

7) Since this non-contact power feeding apparatus 15 is of course composed of the magnetic resonance method of the type where the power transmission coil 3 and the power receiving coil 4 are used as the magnetic resonance coil, supply of a large amount of power can be realized under expansion of the air gap G, that is, a large air gap G. Further, this magnetic resonance method is composed of a type where a repeating coil 2 and a resonance circuit 5 (refer to the conventional technology of Fig. 3A), which are independent from the power feeding side circuit 6 and the power receiving side circuit 7, are not provided in the air gap G. A larger amount of power can be fed to the power receiving side circuit 7 because the value of resistance is reduced accordingly.

8) Meanwhile, in the power feeding side circuit 6 of the example shown in Fig. 1, the side of the high-frequency power source 9 and the side of the electric field coupling capacitors 21 and 22, the parallel capacitor 11, the power transmission coil 3 and the like are connected through the insulating transformer 23 (refer to Fig. 1).

The insulating transformer 23 is provided to electrically insulate the side of the high-frequency power source 9 from the side of the electric field coupling capacitors 21 and 22, the parallel capacitor 11 and the power transmission coil 3 to reduce the common-mode current. With this, since the electromagnetic waves radiated outside based on the magnetic field formed between the power transmission coil 3 and the power receiving coil 4 is greatly reduced, a risk of generating electromagnetic disturbance in the neighborhood of the non-contact power feeding apparatus 15 can be prevented.

9) It is to be noted that the terms used in this specification such as "set to have the same resonance frequency", "set to be the same as the resonance frequency", "set to be the resonance frequency", "frequencies of both peaks", "the intermediate frequency of the frequencies of both peaks" and the like do not always require "completely same" or "completely intermediate".

In other words, these terms are to be understood in a broader sense, that is, as a concept meaning the frequency of that level or the frequency of a certain range. If Q-value of the coil is high, the frequency range is narrowly understood and if Q-value is low, the frequency range is widely understood. These terms are basically understood to mean the frequency of a range making the magnetic resonance which is a theme of this invention possible.

Operation and the like are as described above.


**(Examples)**

Examples of the present invention will now be described hereunder.

We run a computer simulation in a case where the non-contact power feeding apparatus 15 of the present invention is implemented in a circuit of Fig. 1 to feed power of about 2 kW to a load L of the power receiving side circuit 7.

In this case, K-value = 0.05, the self-inductance $L_1$ of the power transmission coil 3 = 26.2 (H), and the self-inductance $L_2$ of the power receiving coil 4 = 18.2 (H). The capacitance of the parallel capacitor 11 = 100 n (F), the capacitance of the parallel capacitor 12 = 170 n (F) and the capacitance of the electric field coupling capacitors 21 and 22 = 50 n (F) (The capacitance of the electric field coupling capacitors 21 and 22 is not needed to have the same value as shown above).

As a result of simulation under the conditions described above, the following data was obtained:

High-frequency power source 9:

$$257 \text{ V} \times 10 \text{ A} = (\text{Power}) \text{ supply power of } 2.57 \text{ kW}$$

To the side of a primary coil of the insulating transformer 23:

$$260 \text{ V} \times 10 \text{ A} = \text{Apparent power of } 2.60 \text{ kVA}$$

From a secondary coil of the insulating transformer 23 to the side of low pressure of the electric field coupling capacitors 21 and 22:

$$145 \text{ V} \times 10 \text{ A} = \text{Apparent power of } 1.45 \text{ kVA}$$

From the side of the high pressure of the electric field coupling capacitors 21 and 22 to the power transmission coil 3:

$$1.4 \text{ kV} \times 96 \text{ A} = \text{Apparent power of } 134.4 \text{ kVA}$$

From the power receiving coil 4:

$$420 \text{ V} \times 40 \text{ A} = \text{Apparent power of } 16.8 \text{ kVA}$$

Load L:

$$420 \text{ V} \times 5 \text{ A} = \text{Effective power of } 2.1 \text{ kW}$$

As seen from the above, in the case where power supply of about 2 kW is conducted to the load L of the power receiving circuit 7, in other words, even in the case where the input voltage $V_1$ of about 1.4 kV is required for the power transmission coil 3 of the power feeding side circuit 6, the following results were obtained. The side of the insulating transformer 23 in the power feeding side circuit 6 only needs a low voltage of about 145 V, while the side of the high-frequency power source 9 only needs a low voltage of about 257 V In this manner, it was confirmed that the side of the power-supply unit only needs a low voltage.

The examples are as described above.

**EXPLANATION OF REFERENCE NUMERALS**

1:      Non-contact power feeding apparatus (Conventional example)

2:      Repeating coil

3:      Power transmission coil

4:      Power receiving coil

5:      Resonance circuit

6:      Power feeding side circuit

7:      Power receiving side circuit

8:      Capacitor

9:      High-frequency power source

10:     Non-contact power feeding apparatus (Conventional example)

11:     Parallel capacitor

12:     Parallel capacitor

13:     Magnetic core

14:     Magnetic core

15:     Non-contact power feeding apparatus (Present invention)

16:     Battery

17:     Choke coil

18:     Motor

19:     Converter

20      Inverter

21:     Electric field coupling capacitor

22:     Electric field coupling capacitor

23:     Insulating transformer

24:     Capacitor

A:      Ground

B:      Vehicle

C:      Power feeding stand

G:      Air gap

L:      Load

$V_1$:    Input voltage

V2:     Output voltage

$\phi$ :      Magnetic flux

**Claims**

**1.**   A non-contact power feeding apparatus(15) for implementing a magnetic resonance method in which power is fed through an air gap(G), with no contact, from a power transmission coil(3) of a power feeding side circuit(6) to a power receiving coil(4) of a power receiving side circuit(7), which are closely located to face each other, based on a mutual induction effect of electromagnetic induction, **characterized in that** the power feeding side circuit(6) is provided with the power transmission coil(3) and a parallel capacitor(11) connected in parallel to the power transmission coil(3) to provide a parallel resonance circuit, while the power receiving side circuit(7) is provided with the power receiving coil(4) and a parallel capacitor(12) to provide a parallel resonance circuit, both parallel resonance circuits are set to have the same resonance frequency and a power frequency of a high-frequency power source (9) in the power feeding side circuit(6) is set to be the same as the resonance frequency, wherein, in the power feeding side circuit(6), a circuit section on the side of the high-frequency power source(9) and a circuit section on the side of the parallel capacitor(11) and the power transmission coil(3) are connected by the electric field coupling of electric field coupling capacitors(21) and (22).

2. The non-contact power feeding apparatus(15) for implementing a magnetic resonance method according to claim 1, wherein the electric field coupling capacitors(21) and (22) fulfill a pressure rising function to keep the pressure of the circuit section on the side of the high-frequency power source(9) low and to keep the pressure of the circuit section on the side of the power transmission coil(3) high.

3. The non-contact power feeding apparatus(15) for implementing a magnetic resonance method according to claim 1 or 2, wherein the power feeding side circuit(6) is provided in such a manner that the circuit section on the side of the high-frequency power source(9) and the circuit section on the side of the electric field coupling capacitors(21) and (22), the parallel capacitor(11), and the power transmission coil(3) are connected through an insulating transformer(23).

4. The non-contact power feeding apparatus(15) for implementing a magnetic resonance method according to claim 1, 2 or 3, wherein the power feeding side circuit(6) such as the power transmission coil(3) is fixedly disposed on the side of a ground surface, a road surface, a floor surface or other ground, while the power receiving side circuit(7) such as the power receiving coil(4) is mounted on the side of a vehicle or other movable body.

5. The non-contact power feeding apparatus(15) for implementing a magnetic resonance method according to claim 4, wherein power is fed by a stopped-type power feeding method whereby, in the case of power feeding, the power receiving coil(4) is stopped to closely face the stationary power transmission coil(3) through an air gap(G), and the power transmission coil(3) and the power receiving coil(4) are formed in a paired symmetric structure.

6. The non-contact power feeding apparatus(15) for implementing a magnetic resonance method according to any preceding claim, wherein the power transmission coil(3) and the power receiving coil(4) are respectively provided in such a manner that each insulated coil conducting wire is spirally wound more than once on the same plane to provide a totally flat and thin structure.

7. The non-contact power feeding apparatus(15) for implementing a magnetic resonance method according to any preceding claim, wherein the resonance frequency is set based on a frequency response of an output voltage of the power receiving coil(4) to an input voltage into the power transmission coil(3) and the resonance frequency is set to the intermediate frequency of both peaks of bimodal characteristics relating to a specified coupling coefficient in view of the fact that the frequency response shows the bimodal characteristics while responding to a coupling coefficient of an electromagnetic coupling.

FIG.1

Low-pressure side | High-pressure side
(High-frequency power source side) | (Power transmission coil side)

EP 2 475 062 A2

# FIG. 2A

# FIG. 2B

Bimodal frequency response

EP 2 475 062 A2

FIG. 3A

FIG. 3B

FIG. 4A

FIG. 4B

**EP 2 475 062 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010173503 A